# EUROPEAN PATENT APPLICATION

(11) **EP 4 517 533 A1**
(43) Date of publication of application: **05.03.2025**
(21) Application number: 23465529.8
(22) Date of filing: 31.08.2023
(51) Int. Cl.: G06F 11/30, G06F 30/20, G06N 3/02, G06F 11/36

(54) **METHOD AND SYSTEM FOR PREDICTING ENERGY CONSUMPTION OF A COMPUTER PROGRAM**

(71) Applicant: Siemens Aktiengesellschaft, 80333 München (DE)
(72) Inventor: PARVAN, Andrei Leonard, 100245 Ploiesti, Prahova (RO); BALOTA, George, 500142 Brasov (RO); BENCHE, Mihaela Florina, 507190 Sanpetru, Brasov (RO); CATARON, Angel Doru, 500133 Brasov (RO); CRIZBASAN, Amelia, 500218 Brasov (RO)
(74) Representative: Fierascu, Cosmina-Catrinel

(57) **Abstract**

The inventon describes a method of predicting energy consumption of a computer program executed on a device, comprising the steps of: loading a computer program comprising a plurality of assembly instructions of the device, on a simulator of the device, the simulator comprising means for executing the computer program and means for storing a sequence of executed assembly instructions; executing at least one test case on the simulator; calculating a predicted energy consumption based on the sequence of assembly instructions and a predetermined energy consumption associated with each of the assembly instruction comprised in the sequence of assembly instructions

## Description

The invention relates to methods and systems for predicting energy consumption of computer programs executed on industrial edge devices.

IoT edge computing in the production environment relies on industrial edge devices.

These devices may consume various amount of energy depending on use case and depending on software (computer program) which is installed and executed on the device. The same device in the same use case may consume less energy if software is developed with energy efficiency in mind (so called "green software"). The energy efficiency becomes critical when the same software is installed on multiple such devices.

Therefore, it is important to be able to predict the energy consumption of a computer software before deploying it on multiple edge devices.

One known approach is to use additional external devices for energy measurements connected between the power line and the monitored edge device along with a software application which processes the measured data. Such additional measuring device is sometimes difficult to deploy because it may interfere with the system infrastructure.

The aim of the present invention is to provide a method and system for predicting energy consumption of computer programs executed on an edge device, without the need of auxiliary equipment.

According to a first aspect of the present invention there is provided a method of predicting energy consumption of a computer program executed on a device, comprising the following steps:
loading a computer program comprising a plurality of assembly instructions of the device, on a simulator of the device, the simulator comprising means for executing the computer program and means for storing a sequence of executed assembly instructions;
executing at least one test case on the simulator;
calculating a predicted energy consumption based on the sequence of assembly instructions and a predetermined energy consumption associated with each of the assembly instruction comprised in the sequence of assembly instructions.

A test case is typically a specification of the initial conditions and a sequence of steps. Test case may be executed manually, however typically is in a form or computer program, which is executed to verify operation of a particular computer program, system or device (commonly named "test object" or "system under test").

An example of a test step may be:
- sending an input (signal, message, etc.) to a test object via a network interface or via an application programming interface (API),
- waiting for a specified amount of time and/or until a specific output (signal, message, etc.) is provided by a test object via a network interface or via an application programming interface (API).

When a test case is executed, an input sent from the test case to the test object may cause the test object (specifically a computer program) to perform specific actions, resulting in executing a specific sequence of assembly instructions. Preferably, the method further comprises:
loading the computer program on the device;
executing the at least one test case on the device and measuring a real energy consumption of the device during execution of the at least one test case; and
determining a prediction accuracy by comparing the predicted energy consumption with the real energy consumption.

More preferably, the method further comprises:
displaying the predicted energy consumption and the prediction accuracy to a user.

In a preferred embodiment, freely combinable with the previous ones, the association of an assembly instruction with energy consumption is determined by measuring the energy consumption of the device during execution of the assembly instruction on the device.

In yet another preferred embodiment, the method further comprises calculating and displaying a carbon footprint value based on the predicted energy consumption.

In a further aspect, the invention relates to a simulator of a device comprising:
means for executing a same set of assembly instructions as the device, means for storing a sequence of executed assembly instructions; and
means for calculating a predicted energy consumption based on the sequence of assembly instructions and a predetermined energy consumption associated with each of the assembly instruction comprised in the sequence of assembly instructions.

Typically, an edge device comprises a specialized CPU which is capable of executing a specific set of assembly instructions. A simulator is typically a computer program executed on a generic computer, which comprises a CPU capable of executing a different set of assembly instructions than a CPU of an edge device. The simulator computer program emulates the device by translating assembly instructions or blocks of assembly instructions of the device to assembly instructions or blocks of assembly instructions of the generic computer. The simulator according to the present invention additionally comprises means for storing a sequence of executed assembly instructions.

In yet another aspect, the invention relates to a system for predicting energy consumption of a computer program on a device, comprising:
a simulator of the device comprising means for loading a computer program comprising a plurality of assembly instructions of the device, which computer program is the same as the one used by the device,
means for executing at least one test case on the simulator,
means for calculating a predicted energy consumption based on the sequence of assembly instructions and a predetermined energy consumption associated with each of the assembly instruction comprised in the sequence of assembly instructions.

Preferably, the system further comprises the device, wherein the device comprises:
means for loading the computer program on the device; and wherein the system further comprises:
means for executing the (same) at least one test case on the device,
means for measuring a real energy consumption of the device during execution of the at least one test case,
means for determining a prediction accuracy by comparing the predicted energy consumption with the real energy consumption.

More preferably, the system further comprises:
means for and displaying the predicted energy consumption and the prediction accuracy to a user and/or means for calculating and displaying a carbon footprint value based on the predicted energy consumption.

In yet another aspect, the invention relates to a method of predicting energy consumption of a computer program executed on a device, comprising the following steps:
loading a computer program comprising a plurality of assembly instructions of the device, on a simulator of the device, the simulator comprising means for executing the computer program and means for storing a sequence of executed assembly instructions;
executing at least one test case on the simulator;
obtaining a predicted energy consumption by performing inference of the sequence of assembly instructions through a prediction model. Preferably, the method further comprises:
   loading the computer program on the device;
   executing the at least one test case on the device and measuring a real energy consumption of the device during execution of the at least one test case;
   determining a prediction accuracy by comparing the predicted energy consumption with the real energy consumption.

In a preferred embodiment, freely combinable with the previous ones, the prediction model is trained by measuring an energy consumption of the device during execution of at least one sequence of assembly instructions on the device and providing said sequence of assembly instructions as an input and the measured energy consumption as an output to the prediction model.

Any kind of statistical model may be used as the prediction model. As an example, a neural network may be employed, where the input series comprise sequences of assembly instructions and the output series comprise measured energy consumption for respective sequence of assembly instructions.

In addition, the sequence of assembly instructions may be pre-processed in order to fit the data into a specific neural network architecture. An example of such pre-processing is calculating the number of occurrences of each type of assembly instruction in the sequence of assembly instructions and providing only said counts as the input to the prediction model. Other pre-processing methods may be also used, depending on the neural network architecture.

In yet another aspect, the invention relates to a simulator of a device comprising:
means for executing a same set of assembly instructions as the device, means for storing a sequence of executed assembly instructions; and
means for obtaining a predicted energy consumption by performing inference of the sequence of assembly instructions through a prediction model.

In yet another aspect, the invention relates to a system for predicting energy consumption of a computer program on a device, comprising:
a simulator of the device comprising means for loading a computer program comprising a plurality of assembly instructions of the device, which computer program is the same as the one used by the device,
means for executing at least one test case on the simulator,
means for obtaining a predicted energy consumption by performing inference of the sequence of assembly instructions through a prediction model.

Preferably, the system further comprises the device, wherein the device comprises:
means for loading the same computer program as used on the simulator on the device; the system further comprising:
means for executing the at least one test case on the device,
means for measuring a real energy consumption of the device during execution of the at least one test case.

Further features of the present invention will be apparent from the following description of exemplary embodiments with reference to the attached drawings.
Fig. 1 is a block diagram illustrating the hardware components of a computer being part of the simulator according to one embodiment of the invention
Fig. 2 is a flowchart illustrating the method of predicting energy consumption of a computer program according to one embodiment of the invention
Fig. 3 is a block diagram illustrating the logical components of a system according to one embodiment of the invention

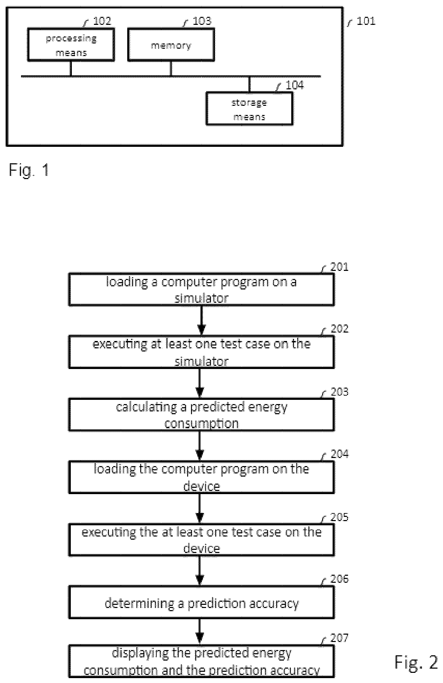

A simulator of a device according to the invention is a computer program having capability of executing same set of assembly instructions as the device and storing a sequence of executed assembly instructions. The simulator can be run on a generic computer presented in Fig. 1, or on a virtual server in a cloud environment.

A generic computer 101, in the most general form includes a processing means 102, which typically is CPU and/or GPU, a memory 103, which is typically RAM, and a storage means 104, which is typically hard disk.

Fig. 2 illustrates the method of predicting energy consumption of a computer program according to one embodiment of the invention. In step 201, a computer program, comprising a plurality of assembly instructions of the device, is loaded on a simulator of the device. Then, in step 202, one or more test cases are executed on the simulator. A test case may for example send one or more inputs to the computer program via an interface (network interface, application programming interface, etc.), causing the computer program to perform one or more specific actions, which result in executing a specific sequence of assembly instructions. The simulator stores the sequence of executed assembly instructions during execution of one or more test cases.

Next, in step 203, a predicted energy consumption is calculated based on the sequence of the subsequently executed assembly instructions on the simulator during the execution of the one or more test cases, and an association of each assembly instruction with predetermined energy consumption. Such association may be determined in an earlier stage by measuring the real energy consumption of the device during the execution of each individual assembly instruction. The measurements may be performed using any known measuring device.

In a simplified example, a device may have 3 possible assembly instructions: A1, A2, A3, each associated with respective energy consumption C1, C2, C3.

During execution of a test case, the following assembly instructions are executed in a sequence: A2, A3, A1, A1, A2, A1. In this simplified example, the calculated prediction of energy consumption would be the following sum: C2+C3+C1+C1+C2+C1.

Alternatively, the predicted energy consumption is obtained performing inference of the sequence of assembly instructions through a prediction model. Such prediction model is trained by measuring an energy consumption of the device during execution of at least one sequence of assembly instructions on the device and providing said sequence of assembly instructions as an input and the measured energy consumption as an output to the prediction model.

Any kind of statistical model may be used as the prediction model. As an example, a neural network may be employed, where the input series comprise sequences of assembly instructions and the output series comprise measured energy consumption for respective sequence of assembly instructions.

In addition, the sequence of assembly instructions may be pre-processed in order to fit the data into a specific neural network architecture. An example of such pre-processing is calculating the number of occurrences of each type of assembly instruction in the sequence of assembly instructions and providing only said counts as the input to the prediction model. Other pre-processing methods may be also used, depending on the neural network architecture.

Once the predicted energy consumption is calculated, the computer program (same as in step 201) is loaded on the device in step 204. Next, in step 205, one or more test cases (same as in step 202) are executed on the device, and the real energy consumption of the device is measured during execution of the one or more test cases. The measurement may be performed using any known measuring device.

Subsequently, in step 206, a prediction accuracy is determined by comparing the predicted energy consumption (from step 203) with the real energy consumption (from step 205).

Finally, in step 207, the predicted energy consumption (from step 203) and the prediction accuracy (from step 206) is displayed to the user.

The method may optionally include calculating and displaying a carbon footprint value based on predicted energy consumption. The calculation of the carbon footprint value may employ a conversion equation that involves multiplying the energy consumption of the device, which is measured in kilowatt-hours (kWh), by the carbon emissions index stated in gCO2eq/kWh.

The user, having the above information, may modify the computer program and execute steps 201-203 and 207 again to check whether the modifications of the program resulted in lower energy consumption. Steps 201-203 and 207 do not involve usage of the device or any additional measuring device, only the simulator of the device is being used.

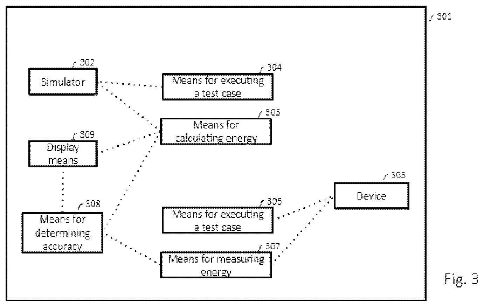

Fig. 3 illustrates the logical components of a system according to one embodiment of the invention. The system 301 includes the simulator 302, the device 303 , means 304 for executing a test case on the simulator, means 305 for calculating predicted energy consumption, means 306 for executing a test case on the device, means 307 for measuring energy consumption, means 308 for determining a prediction accuracy and display means 309.

Means 304-308 may be computer programs running on the same computer/server as the simulator, or on separate computer(s)/server(s) connected to the simulator via one or more network interfaces. Means 306-307 are connected to the device.

In a typical use case, means 304 is used to execute one or more test cases on the simulator. Subsequently, means 305 is used to calculate a predicted energy consumption based on the sequence of executed assembly instructions on the simulator during execution of one or more test cases, and an association of each assembly instruction with predetermined energy consumption. Alternatively, means 305 is used to obtain a predicted energy consumption by performing inference of the sequence of assembly instructions through a prediction model. Next, means 306 is used to execute one or more test cases on the device, and means 307 is used to measure a real energy consumption of the device during execution of one or more test cases, and means 308 is used to determine a prediction accuracy by comparing the predicted energy consumption with the real energy consumption.

Finally, means 309 is used to display the predicted energy consumption and the prediction accuracy to a user.

Although particular embodiments have been disclosed herein in detail, they are done by way of example for purposes of illustration only, and is not intended to be limiting with respect to the scope of the appended claims that follow.

Independent of the grammatical term usage, individuals with male, female or other gender identities are included within the term.

## Claims

1. A method of predicting energy consumption of a computer program executed on a device, comprising:
loading a computer program comprising a plurality of assembly instructions of the device, on a simulator of the device, the simulator comprising means for executing the computer program and means for storing a sequence of executed assembly instructions;
executing at least one test case on the simulator;
calculating a predicted energy consumption based on the sequence of assembly instructions and a predetermined energy consumption associated with each of the assembly instruction comprised in the sequence of assembly instructions.

2. The method according to claim 1, further comprising:
loading the computer program on the device;
executing the at least one test case on the device and measuring a real energy consumption of the device during execution of the at least one test case;
determining a prediction accuracy by comparing the predicted energy consumption with the real energy consumption.

3. The method according to any preceding claim, wherein the predetermined energy consumption associated with each of the assembly instruction is determined by measuring an energy consumption of the device during execution of said assembly instruction on the device.

4. The method according to any preceding claim, further comprising calculating and displaying a carbon footprint value based on the predicted energy consumption.

5. A simulator of a device comprising:
means for executing a same set of assembly instructions as the device, means for storing a sequence of executed assembly instructions; and
means for calculating a predicted energy consumption based on the sequence of assembly instructions and a predetermined energy consumption associated with each of the assembly instruction comprised in the sequence of assembly instructions.

6. A system for predicting energy consumption of a computer program on a device, comprising:
a simulator of the device comprising means for loading a computer program comprising a plurality of assembly instructions of the device, which computer program is the same as the one used by the device,
means for executing at least one test case on the simulator,
means for calculating a predicted energy consumption based on the sequence of assembly instructions and a predetermined energy consumption associated with each of the assembly instruction comprised in the sequence of assembly instructions.

7. The system according to claim 6, further comprising the device, wherein the device comprises:
means for loading the same computer program as used on the simulator on the device; the system further comprising:
means for executing the at least one test case on the device,
means for measuring a real energy consumption of the device during execution of the at least one test case.

8. The system according to claim 7, further comprising:
means for determining a prediction accuracy by comparing the predicted energy consumption with the real energy consumption.

9. The system according to claim 7 or 8, further comprising:
means for calculating and displaying a carbon footprint value based on the predicted energy consumption.

10. A method of predicting energy consumption of a computer program executed on a device, comprising:
loading a computer program comprising a plurality of assembly instructions of the device, on a simulator of the device, the simulator comprising means for executing the computer program and means for storing a sequence of executed assembly instructions;
executing at least one test case on the simulator;
obtaining a predicted energy consumption by performing inference of the sequence of assembly instructions through a prediction model.

11. The method according to claim 10, further comprising:
loading the computer program on the device;
executing the at least one test case on the device and measuring a real energy consumption of the device during execution of the at least one test case;
determining a prediction accuracy by comparing the predicted energy consumption with the real energy consumption.

12. The method according to any of the claims 10-11, wherein the prediction model is trained by measuring an energy consumption of the device during execution of at least one sequence of assembly instructions on the device and providing said sequence of assembly instructions as an input and the measured energy consumption as an output to the prediction model.

13. A simulator of a device comprising:
means for executing a same set of assembly instructions as the device, means for storing a sequence of executed assembly instructions; and
means for obtaining a predicted energy consumption by performing inference of the sequence of assembly instructions through a prediction model.

14. A system for predicting energy consumption of a computer program on a device, comprising:
a simulator of the device comprising means for loading a computer program comprising a plurality of assembly instructions of the device, which computer program is the same as the one used by the device,
means for executing at least one test case on the simulator,
means for obtaining a predicted energy consumption by performing inference of the sequence of assembly instructions through a prediction model.

15. The system according to claim 14, further comprising the device, wherein the device comprises:
means for loading the same computer program as used on the simulator on the device; the system further comprising:
means for executing the at least one test case on the device,
means for measuring a real energy consumption of the device during execution of the at least one test case.
